# EUROPEAN PATENT APPLICATION

(11) **EP 4 631 674 A1**
(43) Date of publication of application: **15.10.2025**
(21) Application number: 23900458.3
(22) Date of filing: 22.11.2023
(51) Int. Cl.: B24B 41/06, B24B 7/00, B24B 9/00, B24B 21/00, H01L 21/677

(54) **SUBSTRATE PROCESSING DEVICE**

(30) Priority: 09.12.2022 JP 2022197122; 09.12.2022 JP 2022197125
(71) Applicant: EBARA CORPORATION, Ota-ku, Tokyo 144-8510 (JP)
(72) Inventor: YAMANOBE, Hokuto, Tokyo 144-8510 (JP); KOBAYASHI, Kenichi, Tokyo 144-8510 (JP); YAZAWA, Akihiro, Tokyo 144-8510 (JP); ISHIKAWA, Sho, Tokyo 144-8510 (JP)
(74) Representative: Klang, Alexander H.
(86) International application number: PCT/JP2023/041941
(87) International publication number: WO 2024/122339

(57) **Abstract**

A substrate processing apparatus includes a plurality of polishing modules polishing a substrate, and a transport unit moving the substrate between the plurality of polishing modules. The plurality of polishing modules include a first module group and a second module group. The transport unit is positioned between the first module group and the second module group in a plan view. The first module group includes a first upper lane and a first lower lane in each of which at least two of the polishing modules are disposed adjacent to each other. The second module group includes a second upper lane and a second lower lane in each of which at least two of the polishing modules are disposed adjacent to each other.

## Description

### TECHNICAL FIELD

The present invention relates to a substrate processing apparatus.

Priority is claimed on Japanese Patent Application No. 2022-197122, filed December 9, 2022, and Japanese Patent Application No. 2022-197125, filed December 9, 2022, the contents of which are incorporated herein by reference.

### BACKGROUND ART

Conventionally, substrate processing apparatuses that remove minute defects from a substrate by polishing are known. For example, Patent Document 1 discloses an apparatus for polishing a bevel portion of a substrate. When minute defects are removed from a substrate using such an apparatus, for example, it is possible to obtain advantages such as suppression of yield loss during semiconductor manufacturing.

### Citation List

### Patent Document

Patent Document 1: Japanese Unexamined Patent Application, First Publication No. 2022-63417

### SUMMARY OF INVENTION

### Problem to be Solved by the Invention

Incidentally, in the substrate processing apparatus as described above, it has been desired to realize processing in which polishing of a plurality of substrates is carried out simultaneously, that is, parallel processing.

Also, in the substrate processing apparatus as described above, it has been desired to efficiently realize processing in which polishing of a plurality of substrates is carried out simultaneously, that is, parallel processing.

The present invention has been made in consideration of such circumstances, and an objective of the present invention is to provide a substrate processing apparatus capable of performing parallel processing of a plurality of substrates.

Further, the present invention has been made in consideration of such circumstances, and an objective of the present invention is to provide a substrate processing apparatus capable of efficiently performing parallel processing of a plurality of substrates. Means to Solve the Problem

In order to solve the above-described problems, a substrate processing apparatus according to aspect 1 of the present invention includes a plurality of polishing modules polishing a substrate, and a transport unit moving the substrate among the plurality of polishing modules, in which the plurality of polishing modules include a first module group and a second module group, the transport unit is positioned between the first module group and the second module group in a plan view, the first module group includes a first upper lane in which at least two of the polishing modules are disposed adjacent to each other, and a first lower lane in which at least two of the polishing modules are disposed adjacent to each other and which is disposed below the first upper lane, and the second module group includes a second upper lane in which at least two of the polishing modules are disposed adjacent to each other, and a second lower lane in which at least two of the polishing modules are disposed adjacent to each other and which is disposed below the second upper lane.

Also, according to aspect 2 of the present invention, in the substrate processing apparatus of aspect 1, the polishing module may have a housing exposed to the outside.

Also, according to aspect 3 of the present invention, in the substrate processing apparatus of aspect 2, the housing may have an opening formed for moving the substrate between the transport unit and the polishing module.

Also, according to aspect 4 of the present invention, in the substrate processing apparatus of any one of aspects 2 to 3, a filter fan unit may be provided in the housing.

Also, according to aspect 5 of the present invention, in the substrate processing apparatus of any one of aspects 2 to 4, the polishing module may be connected to a side surface of the transport unit.

Also, according to aspect 6 of the present invention, in the substrate processing apparatus of any one of aspects 1 to 5, the polishing module may be configured to be attachable and detachable.

Also, according to aspect 7 of the present invention, in the substrate processing apparatus of aspect 6, in at least one of the first upper lane, the first lower lane, the second upper lane, and the second lower lane, an order in which at least two of the polishing modules are disposed may be changeable.

Also, according to aspect 8 of the present invention, in the substrate processing apparatus of any one of aspects 1 to 7, the plurality of polishing modules may include at least one surface polishing module polishing a surface of the substrate, at least one bevel polishing module polishing a bevel portion of the substrate, and at least one back surface polishing module polishing a back surface of the substrate.

In order to solve the above-described problems, a substrate processing apparatus according to aspect 9 of the present invention includes a transport unit including an upper transport device transporting a first substrate and a lower transport device transporting a second substrate, an upper lane including a plurality of polishing modules which are provided to be arranged in a transport direction of the upper transport device and polish the first substrate, and a lower lane including a plurality of polishing modules which are provided to be arranged in a transport direction of the lower transport device and polish the second substrate, in which the polishing modules are each attachable to and detachable from the transport unit, the upper lane and the lower lane are disposed in parallel at different height positions, the upper transport device performs transfer of the first substrate between itself and the upper lane, and the lower transport device performs transfer of the second substrate between itself and the lower lane.

Also, according to aspect 10 of the present invention, in the substrate processing apparatus of aspect 9, the transport unit may further include an upper movement rail extending in a transport direction of the upper transport device, and a lower movement rail extending in a transport direction of the lower transport device, the upper transport device may be movable along the upper movement rail, and the lower transport device may be movable along the lower movement rail.

Also, according to aspect 11 of the present invention, the substrate processing apparatus of aspect 9 or 10 may include a plurality of the transport units, in which the plurality of transport units may be aligned in a transport direction of the upper transport device and the lower transport device.

Also, according to aspect 12 of the present invention, in the substrate processing apparatus of any one of aspects 9 to 11, the polishing modules constituting the upper lane may include at least one surface polishing module polishing a surface of the first substrate, at least one back surface polishing module polishing a back surface of the first substrate, and at least one bevel polishing module polishing a bevel portion of the first substrate, and the polishing modules constituting the lower lane may include at least one surface polishing module polishing a surface of the second substrate, at least one back surface polishing module polishing a back surface of the second substrate, and at least one bevel polishing module polishing a bevel portion of the second substrate. Effects of the Invention

According to the above-described aspects of the present invention, it is possible to provide a substrate processing apparatus capable of performing parallel processing of a plurality of substrates.

Further, according to the above-described aspects of the present invention, it is possible to provide a substrate processing apparatus capable of efficiently performing parallel processing of a plurality of substrates.

### BRIEF DESCRIPTION OF DRAWINGS

[FIG. 1] A perspective view illustrating a substrate processing apparatus according to an embodiment of the present invention.
[FIG. 2] An exploded view illustrating the substrate processing apparatus according to the embodiment of the present invention.
[FIG. 3] A plan view illustrating the substrate processing apparatus according to the embodiment of the present invention.
[FIG. 4] A cross-sectional view along line IV-IV illustrated in FIG. 3, and a view illustrating an outline of a surface polishing module.
[FIG. 5] A view illustrating an outline of a bevel polishing module according to the embodiment of the present invention.
[FIG. 6] A view illustrating an outline of a back surface polishing module according to the embodiment of the present invention.
[FIG. 7] A configuration diagram illustrating the substrate processing apparatus according to the embodiment of the present invention.
[FIG. 8] A configuration diagram illustrating a first modified example of the substrate processing apparatus according to the embodiment of the present invention.
[FIG. 9] A configuration diagram illustrating a second modified example of the substrate processing apparatus according to the embodiment of the present invention.
[FIG. 10] A configuration diagram illustrating a third modified example of the substrate processing apparatus according to the embodiment of the present invention.

### DESCRIPTION OF EMBODIMENTS

Hereinafter, a substrate processing apparatus according to an embodiment of the present invention will be described on the basis of the drawings.

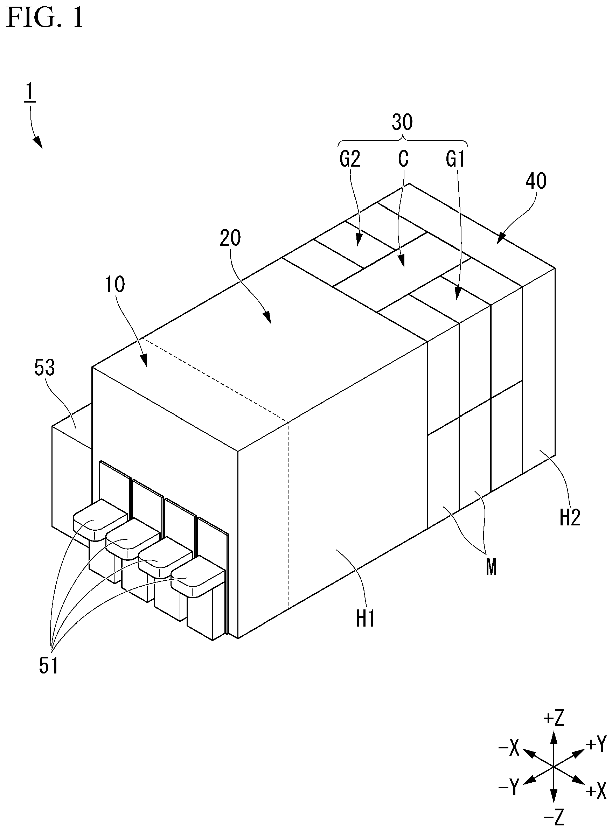

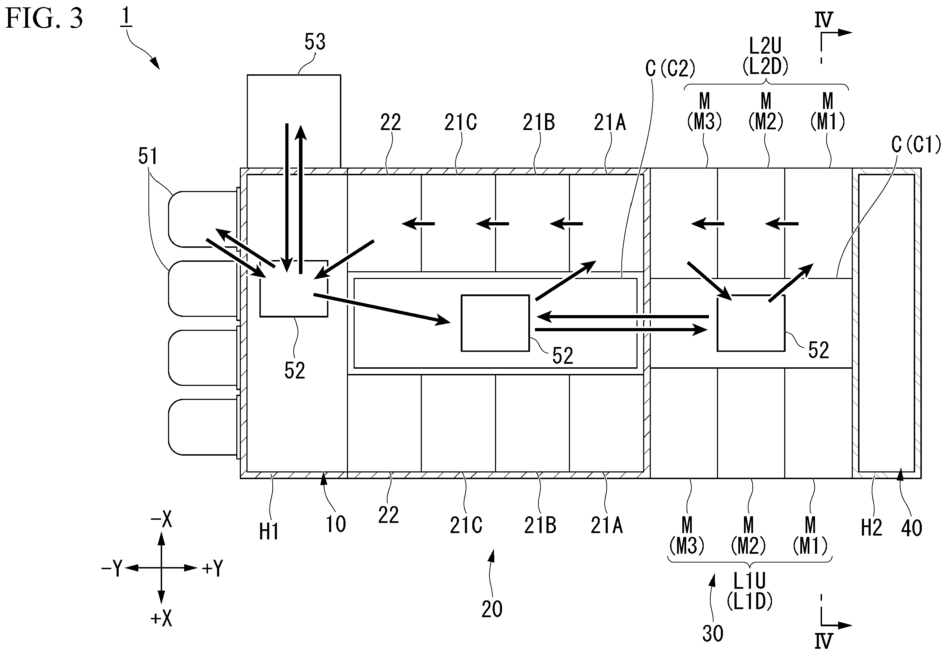

As illustrated in FIGS. 1 to 3, a substrate processing apparatus 1 according to the present embodiment includes an EFEM 10, a cleaning and drying unit 20, a treatment unit 30, a control unit 40, a plurality of load ports 51, and a measurement unit 53. As illustrated in FIG. 3, each of the EFEM 10, the cleaning and drying unit 20, and the treatment unit 30 has at least one transport device 52. The EFEM 10 and the cleaning and drying unit 20 are housed in a first outer housing H1. The control unit 40 is housed in a second outer housing H2. The control unit 40 comprehensively controls an operation of the substrate processing apparatus 1.

As illustrated in FIG. 1, the EFEM 10, the cleaning and drying unit 20, the treatment unit 30, and the control unit 40 according to the present embodiment are disposed to be arranged in one direction. Also, the EFEM 10, the cleaning and drying unit 20, the treatment unit 30, and the control unit 40 are arranged in this order in the direction.

### (Definition of directions)

In the present specification, a direction in which the EFEM 10, the cleaning and drying unit 20, the treatment unit 30, and the control unit 40 are arranged is referred to as a transport direction Y. The transport direction Y is also a direction in which lanes L1U, L1D, L2U, and L2D to be described later extend. A direction from the EFEM 10 toward the control unit 40 in the transport direction Y is referred to as a +Y direction or a rearward side. A direction opposite to the +Y direction is referred to as a -Y direction or a forward side. One direction intersecting the transport direction Y is referred to as a left-right direction X. One direction in the left-right direction X is referred to as a +X direction or rightward. A direction opposite to the +X direction is referred to as a -X direction or leftward. A direction intersecting both the left-right direction X and the transport direction Y is referred to as a vertical direction Z. One direction in the vertical direction Z is referred to as a +Z direction or upward. A direction opposite to the +Z direction is referred to as a -Z direction or downward. For example, the vertical direction Z is a direction of gravity (vertical direction), and the left-right direction X and the transport direction Y are horizontal directions. However, the vertical direction Z may be inclined with respect to the direction of gravity, and the horizontal direction X and the transport direction Y may be inclined with respect to the horizontal direction.

As illustrated in FIGS. 1 to 3, the treatment unit 30 according to the present embodiment has a plurality of (twelve in the illustrated example) polishing modules M and a transport unit C (first transport unit C1). Each of the polishing modules M polishes a substrate W to remove defects on the substrate W. Examples of "defects on the substrate W" include particles, a metal adhered to the substrate W, dust embedded (sunk) into the substrate W, fine irregularities on the substrate W, and the like.

In the present embodiment, each of the plurality of polishing modules M is one of a surface polishing module M1, a bevel polishing module M2, and a back surface polishing module M3. The surface polishing module M1 is a module that polishes a surface of the substrate W. The bevel polishing module M2 is a module that polishes a bevel portion (outer circumferential portion) of the substrate W. The back surface polishing module M3 is a module that polishes a back surface of the substrate W.

The plurality of polishing modules M include a first module group G1 and a second module group G2. In the illustrated example, each of the first module group G1 and the second module group G2 has six polishing modules M. In a plan view, the transport unit C (first transport unit C1) is positioned between the first module group G1 and the second module group G2. More specifically, the first module group G1 and the second module group G2 are disposed to sandwich the transport unit C (first transport unit C1) therebetween in the left-right direction X. The first module group G1 is disposed on a right side (+X side) of the transport unit C (first transport unit C1). The second module group G2 is disposed on a left side (-X side) of the transport unit C (first transport unit C1).

The first module group G1 includes a first upper lane L1U and a first lower lane L1D disposed below the first upper lane L1U. The second module group G2 includes a second upper lane L2U and a second lower lane L2D disposed below the second upper lane L2U. In each of the lanes L1U, L1D, L2U, and L2D, the plurality of (three in the illustrated example) polishing modules M are disposed adjacent to each other in the transport direction Y. More specifically, in each of the lanes L1U, L1D, L2U, and L2D in the present embodiment, the surface polishing module M1, the bevel polishing module M2, and the back surface polishing module M3 are disposed to be arranged in this order from the rear side (+Y side) to the front side (-Y side).

The first upper lane L1U and the first lower lane L1D are disposed in parallel at different height positions. That is, the first upper lane L1U and the first lower lane L1D are vertically disposed in parallel. The second upper lane L2U and the second lower lane L2D are disposed in parallel at different height positions. That is, the second upper lane L2U and the second lower lane L2D are vertically disposed in parallel.

Each of the first upper lane L1U and the second upper lane L2U is an example of an upper lane. Each of the first lower lane L1D and the second lower lane L2D is an example of a lower lane.

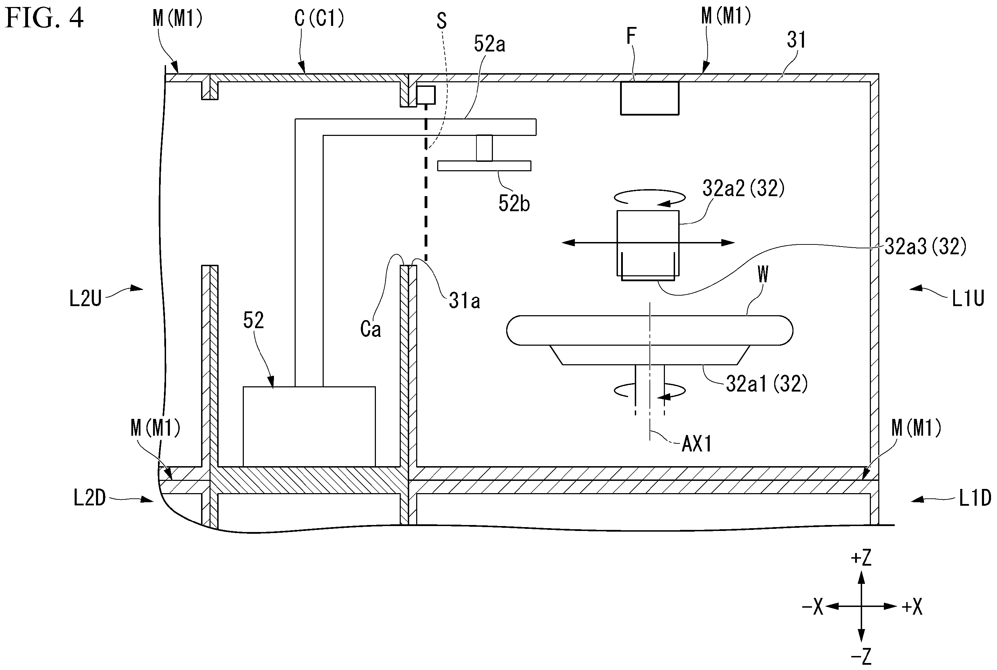

As illustrated in FIGS. 4 to 6, each polishing module M includes a housing 31 and a processing device 32 housed in the housing 31. The housing 31 is not housed in the outer housings H1 and H2 and is exposed to the outside of the substrate processing apparatus 1.

Each polishing module M is connected to a side surface (a surface facing outward in the left-right direction X in the illustrated example) of the transport unit C (first transport unit C1). Also, each polishing module M according to the present embodiment is configured to be attachable to and detachable from the transport unit C. Further, the polishing modules M1, M2, and M3 have substantially the same outer shape. Thereby, in each of the lanes L1U, L1D, L2U, and L2D, it is possible to change an order in which the polishing modules M1, M2, and M3 are disposed. Further, the phrase "substantially the same outer shape" also includes a case in which outer shapes are the same if manufacturing errors are disregarded.

The housing 31 has an opening 31a formed for moving the substrate W between the transport unit C and the polishing module M. A shutter S capable of switching between a closed state and an open state is provided in the housing 31 according to the present embodiment. The closed state is a state in which the shutter S closes the opening 31a. The open state is a state in which the shutter S does not close the opening 31a.

Also, a filter fan unit F is provided in the housing 31 according to the present embodiment. The filter fan unit F includes a clean air filter such as a HEPA filter, a ULPA filter, or a chemical filter. The filter fan unit F constantly blows clean air, from which particles, toxic vapors, toxic gases, and the like have been removed, into the housing 31. Thereby, the filter fan unit F maintains the inside of the housing 31 in a clean state.

A specific configuration of the processing device 32 may differ depending on a type of the polishing module M. That is, a configuration of the processing device 32 in the surface polishing module M1, a configuration of the processing device 32 in the bevel polishing module M2, and a configuration of the processing device 32 in the back surface polishing module M3 may be different from each other. An outline of the configuration of the processing device 32 included in each of the polishing modules M1, M2, and M3 will be described below. Note that, the configuration of the processing device 32 described below is merely an example and can be modified as appropriate.

As illustrated in FIG. 4, the surface polishing module M1 includes, as the processing device 32, for example, a rotation stage 32a1 and a polishing head 32a2. The rotation stage 32a1 is configured to be rotatable about a rotation axis AX1. The substrate W is placed on the rotation stage 32a1. The polishing head 32a2 has, for example, a polishing tape 32a3 for polishing a surface of the substrate W. Abrasive grains are provided on a surface of the polishing tape 32a3. The polishing head 32a2 is configured, for example, to be capable of translational movement and rotational movement on the surface of the substrate W.

While the rotation stage 32a1 and the substrate W rotate around the rotation axis AX1 and the polishing tape 32a3 is in contact with the surface of the substrate W, the polishing head 32a2 performs translational movement and rotational movement. Thereby, the polishing tape 32a3 polishes the surface of the substrate W. Thereby, defects on the surface of the substrate W are removed. In other words, the surface of the substrate W is treated.

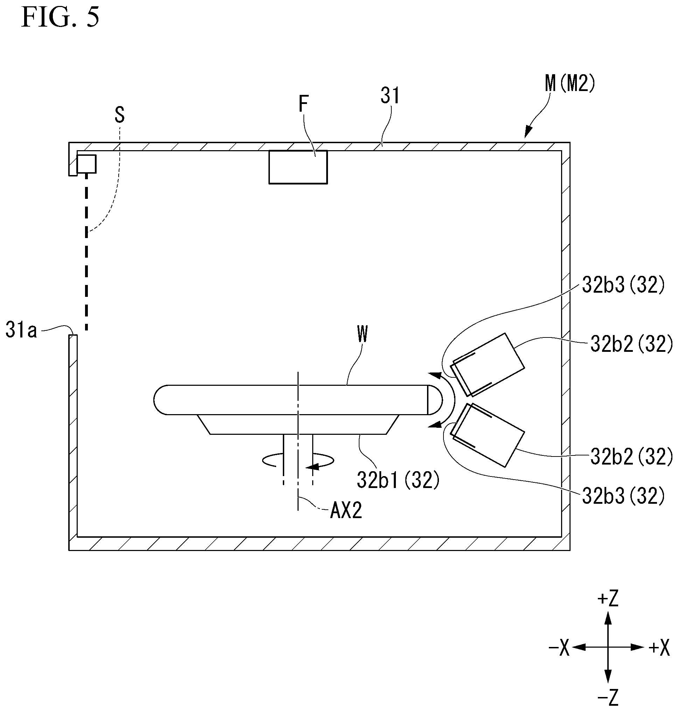

As illustrated in FIG. 5, the bevel polishing module M2 includes, as the processing device 32, for example, a rotation stage 32b1 and a polishing head 32b2. The rotation stage 32b1 is configured to be rotatable about a rotation axis AX2. The substrate W is placed on the rotation stage 32b1. The polishing head 32b2 includes, for example, a polishing tape 32b3 for polishing the bevel portion (outer circumferential portion) of the substrate W. Abrasive grains are provided on a surface of the polishing tape 32b3. The polishing head 32b2 is configured, for example, to be movable along the bevel portion of the substrate W.

While the rotation stage 32b1 and the substrate W rotate around the rotation axis AX2 and the polishing tape 32b3 is in contact with the bevel portion of the substrate W, the polishing head 32b2 moves along the bevel portion. Thereby, the polishing tape 32b3 polishes the bevel portion of the substrate W. Thereby, defects on the bevel portion of the substrate W are removed. In other words, the bevel portion of the substrate W is treated.

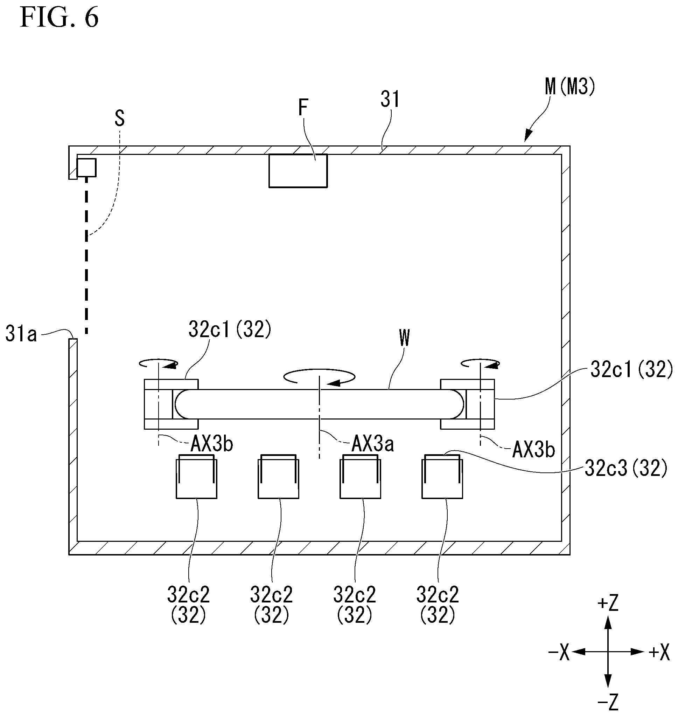

As illustrated in FIG. 6, the back surface polishing module M3 includes, as the processing device 32, for example, a plurality of holding portions 32c1 and a plurality of polishing heads 32c2. The plurality of holding portions 32c1 hold the substrate W in a state in which the substrate W is rotatable around a central axis AX3a of the substrate W. Specifically, a portion (rotating portion) of each holding portion 32c1 is configured to rotate around a central axis AX3b. Then, the rotating portion rotates around the central axis AX3b while being in contact with an outer circumferential portion of the substrate W. Thereby, the substrate W rotates around the central axis AX3a. The polishing head 32c2 has, for example, a polishing tape 32c3 for polishing the back surface of the substrate W. Abrasive grains are provided on a surface of the polishing tape 32C3. The polishing heads 32c2 are disposed, for example, at intervals along the back surface of the substrate W. Each polishing head 32c2 may be configured to be movable along the back surface of the substrate W.

The substrate W rotates around the central axis AX3a by an action of the holding portion 32c1, and the polishing tape 32c3 comes into contact with the back surface of the substrate W. Thereby, the polishing tape 32c3 polishes the back surface of the substrate W. Thereby, defects on the back surface of the substrate W are removed. In other words, the back surface of the substrate W is treated.

It is possible to determine a surface roughness of the polishing tape in each of the surface polishing module M1, the bevel polishing module M2 and the back surface polishing module M3 according to characteristics required for the substrate W.

The transport unit C (first transport unit C1) moves the substrate W among the plurality of polishing modules M. A tipping suppression means for suppressing tipping of the transport unit C may be provided in the transport unit C. Examples of the tipping suppression means include legs, other fixing means, or the like for fixing the transport unit C to an installation surface (a floor surface, a ground surface, or the like). Alternatively, tipping of the transport unit C may be suppressed by making a weight of the transport unit C sufficiently greater than a weight of the polishing module M.

As illustrated in FIG. 4, the transport unit C includes the transport device 52 that transports the substrate W. The transport device 52 includes, for example, an arm 52a and a hand 52b. The transport device 52 may have a plurality of arms 52a and a plurality of hands 52b. Although details will be described later, the transport unit C (first transport unit C1) may have two or more transport devices 52 including an upper transport device 52U and a lower transport device 52D. The upper transport device 52U moves the substrate W in the upper lanes L1U and L2U. The lower transport device 52D moves the substrate W in the lower lanes L1D and L2D.

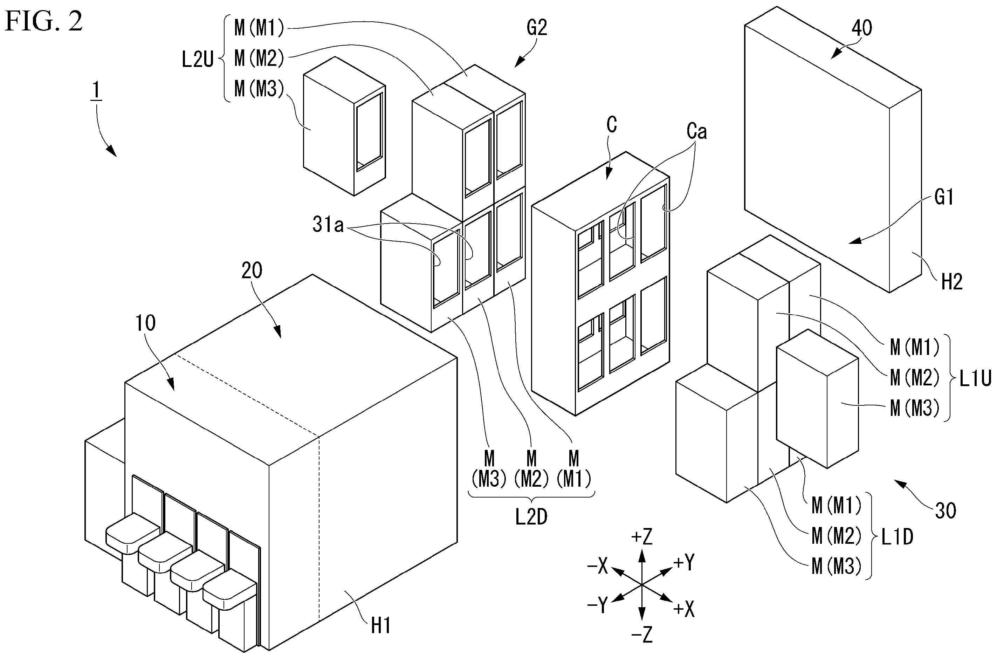

As illustrated in FIGS. 2 and 4, the transport unit C has an opening Ca communicating with the opening 31a provided in the housing 31. The transport device 52 inserts the arm 52a and the hand 52b into the housing 31 and removes them from the housing 31 through the openings Ca and 31a. Thereby, the substrate W is put in and taken out with respect to the housing 31.

Note that, in the illustrated example, the opening 31a of the housing 31 and the opening Ca of the transport unit C have had a one-to-one correspondence, but the correspondence between the openings 31a and the opening Ca is not limited thereto and may be changed as appropriate. For example, one opening Ca may be provided for a plurality of openings 31a. Also, the above-described shutter S may be provided at the opening Ca of the transport unit C instead of at the opening 31a of the housing 31.

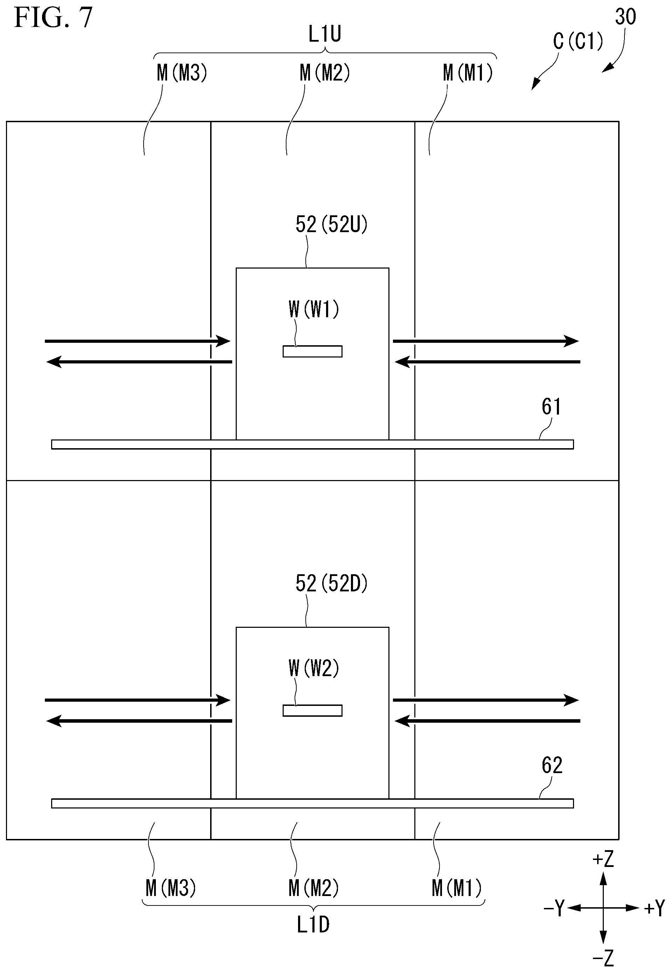

As illustrated in FIG. 7, the transport unit C (first transport unit C1) includes two or more transport devices 52, an upper movement rail 61, and a lower movement rail 62. The two or more transport devices 52 include the upper transport device 52U (first transport device 52U) and the lower transport device 52D (second transport device 52D).

The upper transport device 52U moves the substrate W in the upper lanes L1U and L2U. The substrate W moved in the upper lanes L1U and L2U is referred to as a "first substrate W1". The first substrate W1 is also the substrate W transferred by the upper transport device 52U. The lower transport device 52D moves the substrate W in the lower lanes L1D and L2D. The substrate W moved in the lower lanes L1D and L2D is referred to as a "second substrate W2". The second substrate W2 is also the substrate W transferred by the lower transport device 52D.

The upper transport device 52U is capable of performing transfer of the first substrate W1 between itself and the polishing modules M constituting the upper lanes L1U and L2U. The hand 52b (see FIG. 4) of the upper transport device 52U holds the first substrate W1. The arm 52a is connected to the hand 52b (see FIG. 4). The arm 52a is capable of moving, for example, the hand 52b holding the first substrate W1 within a horizontal plane. The arm 52a is capable of loading the first substrate W1 into the polishing modules M constituting the upper lanes L1U and L2U. The arm 52a is capable of unloading the first substrate W1 from the polishing modules M constituting the upper lanes L1U and L2U.

The lower transport device 52D is capable of performing transfer of the second substrate W2 between itself and the polishing modules M constituting the lower lanes L1D and L2D. The hand 52b (see FIG. 4) of the lower transport device 52D holds the second substrate W2. The arm 52a is connected to the hand 52b (see FIG. 4). The arm 52a is capable of moving, for example, the hand 52b holding the second substrate W2 within a horizontal plane. The arm 52a is capable of loading the second substrate W2 into the polishing modules M constituting the lower lanes L1D and L2D. The arm 52a is capable of unloading the second substrate W2 from the polishing modules M constituting the lower lanes L1D and L2D.

The upper movement rail 61 is provided to be disposed in the transport direction Y of the upper transport device 52U. The upper transport device 52U is movable along the upper movement rail 61. When the upper transport device 52U performs transfer of the first substrate W1 between itself and the polishing modules M constituting the upper lanes L1U and L2U, it is possible to adjust a position of the upper transport device 52U in the transport direction Y along the upper movement rail 61 as necessary.

The lower movement rail 62 is provided to be disposed in the transport direction Y of the lower transport device 52D. The lower transport device 52D is movable along the lower movement rails 62. When the lower transport device 52D performs transfer of the second substrate W2 between itself and the polishing modules M constituting the lower lanes L1D and L2D, it is possible to adjust a position of the lower transport device 52D in the transport direction Y along the lower movement rail 62 as necessary.

As illustrated in FIG. 3, the cleaning and drying unit 20 includes a plurality of cleaning sections 21A to 21C, a plurality of drying sections 22, and a transport unit C (second transport unit C2). The plurality of cleaning sections 21A to 21C and the plurality of drying sections 22 are provided corresponding to the respective lanes L1U, L1D, L2U, and L2D of the treatment unit 30. In the illustrated example, three cleaning sections 21A, 21B, and 21C and one drying section 22 are provided for each of the lanes L1U, L1D, L2U, and L2D. The cleaning sections 21A to 21C and the drying section 22 are disposed to be arranged in this order from the rear side (+Y side) to the front side (-Y side). The second transport unit C2 moves the substrate W among the plurality of cleaning sections 21A to 21C and the drying section 22 using the transport device 52. A configuration of the second transport unit C2 may be the same as the configuration of the first transport unit C1.

Next, an example of processing performed on the substrate W in the substrate processing apparatus 1 configured as described above will be explained on the basis of FIG. 3.

First, the substrate W is placed on the load port 51 by an operator or the like. The substrate W placed on the load port 51 is transported to the surface polishing module M1 by the transport device 52 of the EFEM 10, the transport device 52 of the second transport unit C2, and the transport device 52 of the first transport unit C1. The surface polishing module M1 is the polishing module M positioned at a rearmost side (+Y side). At this time, the substrate W is transported to any one of the lanes L1U, L1D, L2U, and L2D. The surface of the substrate W is polished by the surface polishing module M1.

A surface of the substrate W (first substrate W1) is polished by the surface polishing module M1 in each of the upper lanes L1U and L2U (see FIGS. 2 and 7). The substrate W (first substrate W1) whose surface has been polished in the surface polishing module M1 is transported to the bevel polishing module M2 in the same lane by the transport device 52 (upper transport device 52U) of the first transport unit C1. A bevel portion of the substrate W (first substrate W1) is polished by the bevel polishing module M2. The substrate W (first substrate W1) whose bevel portion has been polished in the bevel polishing module M2 is transported to the back surface polishing module M3 in the same lane by the transport device 52 (upper transport device 52U). A back surface of the substrate W (first substrate W1) is polished by the back surface polishing module M3. The substrate W (first substrate W1) whose back surface has been polished by the back surface polishing module M3 is transported to the cleaning section 21A by the transport device 52 of the first transport unit C1 and the transport device 52 of the second transport unit C2 (see FIG. 3). The substrate W is cleaned by the cleaning section 21A.

A surface of the substrate W (second substrate W2) is polished by the surface polishing module M1 in each of the lower lanes L1D and L2D (see FIGS. 2 and 7). The substrate W (second substrate W2) whose surface has been polished in the surface polishing module M1 is transported to the bevel polishing module M2 in the same lane by the transport device 52 (lower transport device 52D) of the first transport unit C1. A bevel portion of the substrate W (second substrate W2) is polished by the bevel polishing module M2. The substrate W (second substrate W2) whose bevel portion has been polished in the bevel polishing module M2 is transported to the back surface polishing module M3 in the same lane by the transport device 52 (lower transport device 52D). A back surface of the substrate W (second substrate W2) is polished by the back surface polishing module M3. The substrate W (second substrate W2) whose back surface has been polished by the back surface polishing module M3 is transported to the cleaning section 21A by the transport device 52 of the first transport unit C1 and the transport device 52 of the second transport unit C2 (see FIG. 3). The substrate W is cleaned by the cleaning section 21A.

The substrate W cleaned by the cleaning section 21A is transported to the cleaning section 21B by the transport device 52 of the second transport unit C2, and is cleaned by the cleaning section 21B. The substrate W cleaned by the cleaning section 21B is transported to the cleaning section 21C by the transport device 52 of the second transport unit C2, and is cleaned by the cleaning section 21C. The substrate W cleaned by the cleaning section 21C is transported to the drying section 22 by the transport device 52 of the second transport unit C2, and is dried by the drying section 22. The substrate W dried by the drying section 22 is transported to the measurement unit 53 by the transport device 52 of the EFEM 10. The measurement unit 53 measures a state of defects remaining on the substrate W. The substrate W that has been measured by the measurement unit 53 is unloaded to the load port 51 by the transport device 52 of the EFEM 10. Note that, the substrate processing apparatus 1 may include a temporary placement table on which the substrate W is temporarily placed when the transport device 52 transports the substrate W.

As described above, the substrate processing apparatus 1 according to the present embodiment includes the plurality of polishing modules M polishing the substrate W, and the transport unit C (first transport unit C1) moving the substrate W among the plurality of polishing modules M, in which the plurality of polishing modules M include the first module group G1 and the second module group G2, the transport unit C is positioned between the first module group G1 and the second module group G2 in a plan view, the first module group G1 includes the first upper lane L1U in which the plurality of polishing modules M are disposed adjacent to each other, and the first lower lane L1D in which the plurality of polishing modules M are disposed adjacent to each other and which is disposed below the first upper lane L1U, and the second module group G2 includes the second lower lane L2D in which the plurality of polishing modules M are disposed adjacent to each other and which is disposed below the second upper lane L2U.

With this configuration, it is possible to realize parallel processing of the substrates W using the four lanes L1U, L1D, L2U, and L2D, and to improve a processing speed of the substrates W. Also, since processing by polishing is performed on the substrate W, it is possible to remove defects that cannot be removed by non-contact cleaning using a chemical solution or the like, or by processing using a brush or the like.

Also, the polishing module M has the housing 31 exposed to the outside. In other words, the polishing module M is not housed in the outer housings H1 and H2. With this configuration, it becomes easier to realize a configuration in which the polishing module M is attachable to and detachable from the transport unit C.

Also, the housing 31 has the opening 31a formed for moving the substrate W between the transport unit C and the polishing module M. With this configuration, it is possible to smoothly perform movement of the substrate W between the transport unit C and the polishing module M.

Also, the filter fan unit F is provided in the housing 31. With this configuration, it is possible to independently control an airflow within each polishing module M, and to maintain the polishing modules M in a clean state.

Also, the polishing module M is connected to a side surface of the transport unit C. With this configuration, it becomes easier to realize a configuration in which the polishing module M is attachable to and detachable from the transport unit C.

Moreover, the polishing module M is configured to be attachable and detachable. With this configuration, it is possible to remove the polishing module M as necessary for inspection or replacement.

Also, in each of the first upper lane L1U, the first lower lane L1D, the second upper lane L2U, and the second lower lane L2D, an order in which the polishing modules M are disposed is changeable. According to this configuration, it is possible to change an order of processing applied to the substrate W by changing the order in which the polishing modules M are disposed.

Also, the plurality of polishing modules M include at least one surface polishing module M1 for polishing a surface of the substrate W, at least one bevel polishing module M2 for polishing a bevel portion of the substrate W, and at least one back surface polishing module M3 for polishing a back surface of the substrate W. With this configuration, it is possible to provide the substrate processing apparatus 1 capable of polishing (treating) all of the surface, bevel portion, and back surface of the substrate W using a single apparatus.

Also, as described above, the substrate processing apparatus 1 according to the present embodiment is capable of realizing parallel processing of the substrates W using the upper lanes L1U and L2U and the lower lanes L1D and L2D, and it is possible to improve a processing speed of substrates W. Also, since processing by polishing is performed on the substrate W, it is possible to remove defects that cannot be removed by non-contact cleaning using a chemical solution or the like, or by processing using a brush or the like.

The transport unit C (first transport unit C1) includes the upper transport device 52U and the lower transport device 52D. The upper transport device 52U performs transfer of the substrate W (first substrate W1) between itself and the upper lanes L1U and L2U. The lower transport device 52D performs transfer of the substrate W (second substrate W2) between itself and the lower lanes L1D and L2D. With this configuration, the substrate processing apparatus 1 is capable of processing the first substrate W1 and the second substrate W2 in parallel. Therefore, it is possible to improve an efficiency of processing the substrate W.

The transport unit C (first transport unit C1) includes the upper movement rail 61 and the lower movement rail 62. With this configuration, it is possible for the substrate processing apparatus 1 to adjust a position of the transport device 52 (upper transport device 52U and lower transport device 52D) in the transport direction Y. Therefore, it is possible to dispose the transport device 52 at a position suitable for transfer of the substrate W. Therefore, it is possible to easily perform transfer of the substrate W between the transport device 52 and the polishing module M.

The polishing modules M constituting the upper lanes L1U and L2U include the surface polishing module M1, the bevel polishing module M2, and the back surface polishing module M3. The polishing modules M constituting the lower lanes L1D and L2D include the surface polishing module M1, the bevel polishing module M2, and the back surface polishing module M3. With this configuration, it is possible to provide the substrate processing apparatus 1 capable of polishing (treating) all of the surface, bevel portion, and back surface of the substrate W (the first substrate W1 and the second substrate W2) using a single apparatus.

In each of the first upper lane L1U, the first lower lane L1D, the second upper lane L2U, and the second lower lane L2D, it is possible to set an order in which the substrate W is processed in the plurality of polishing modules M arbitrarily. For example, the substrate W may be processed in an order of the surface polishing module M1, the bevel polishing module M2, and the back surface polishing module M3. Alternatively, by changing a transfer order of the substrate W by the transport device 52, it may be processed in an order of the back surface polishing module M3, the bevel polishing module M2, and the surface polishing module M1. Thereby, it is possible to set the order in which the substrate W is processed by the polishing modules M arbitrarily without changing disposition of the plurality of polishing modules M.

It is possible to set the transfer order of the substrate W by the control unit 40.

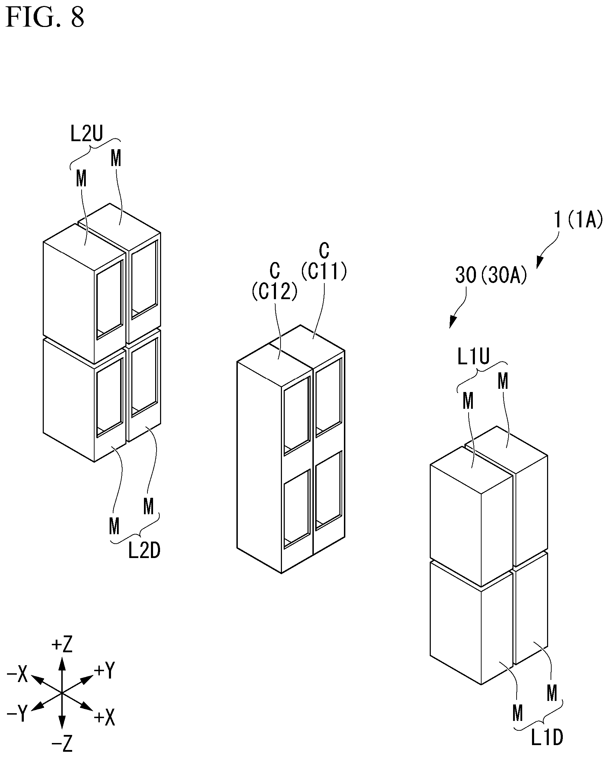

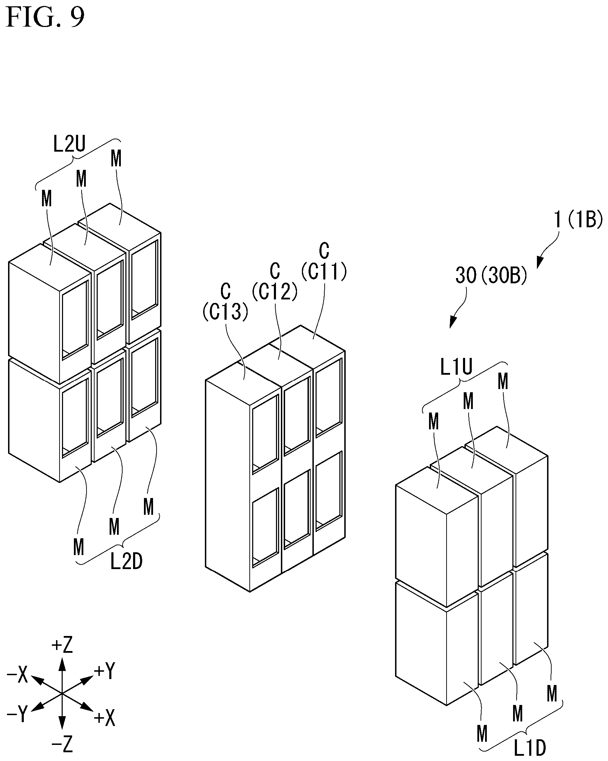

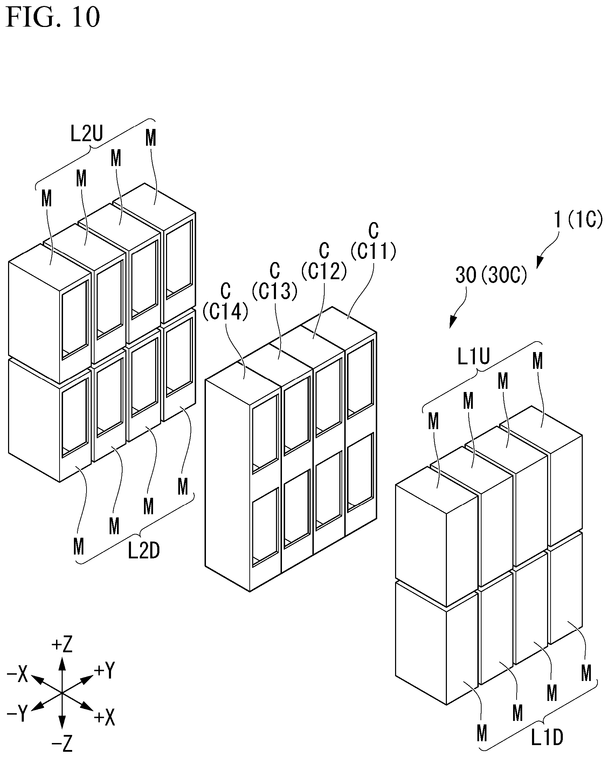

FIG. 8 is a configuration diagram illustrating a substrate processing apparatus 1A which is a first modified example of the substrate processing apparatus 1. FIG. 9 is a configuration diagram illustrating a substrate processing apparatus 1B which is a second modified example of the substrate processing apparatus 1. FIG. 10 is a configuration diagram illustrating a substrate processing apparatus 1C which is a third modified example of the substrate processing apparatus 1.

As illustrated in FIGS. 8 to 10, the treatment unit 30 of the substrate processing apparatuses 1A to 1C includes the plurality of transport units C and the lanes L1U, L1D, L2U, and L2D. The number of polishing modules M constituting each of the lanes L1U, L1D, L2U, and L2D is equal to the number of the transport units C.

As illustrated in FIG. 8, the treatment unit 30 (treatment unit 30A) of the substrate processing apparatus 1A includes two transport units C (C11 and C12) and the lanes L1U, L1D, L2U, and L2D. The number of the polishing modules M constituting each of the lanes L1U, L1D, L2U, and L2D is two. The two transport units C11 and *C12* are arranged in the transport direction Y.

As illustrated in FIG. 9, the treatment unit 30 (treatment unit 30B) of the substrate processing apparatus 1B includes three transport units C (C11, C12*,* and C13) and lanes L1U, L1D, L2U, and L2D. The number of polishing modules M constituting each of the lanes L1U, L1D, L2U, and L2D is three. The three transport units C11, C12, and C13 are arranged in the transport direction Y.

As illustrated in FIG. 10, the treatment unit 30 (treatment unit 30C) of the substrate processing apparatus 1C includes four transport units C (C11, C12, C13, and C14) and lanes L1U, L1D, L2U, and L2D. The number of polishing modules M constituting each of the lanes L1U, L1D, L2U, and L2D is four. The four transport units C11, C12, C13, and C14 are arranged in the transport direction Y.

Note that, the number of the transport units C is not particularly limited. The transport units C may be one or a plurality. Then, the plurality of transport units C may be arranged in the transport direction Y. The term "plurality" refers to any number of two or more.

According to the substrate processing apparatuses 1A to 1C, it is possible to select a transport unit having an optimal configuration in accordance with a configuration of the lanes L1U, L1D, L2U, and L2D. The substrate processing apparatuses 1A to 1C is capable of being configured with an appropriate number of transport units without excess or deficiency. Therefore, it is possible to achieve a reduction in size of the apparatus and improvement in processing efficiency.

The numbers of the upper transport devices and the lower transport devices may each be one for each transport unit C. The numbers of the upper transport devices and lower transport devices may each be one for a plurality of transport units C.

Note that, the technical scope of the present invention is not limited to the above-described embodiments, and various modifications may be made within a range not departing from the spirit of the present invention.

For example, the disposition of the polishing modules M described in the above-described embodiment is merely an example and may be changed as appropriate. Also, the substrate processing apparatus 1 may not include one (or two) of the surface polishing module M1, the bevel polishing module M2, and the back surface polishing module M3. That is, the substrate processing apparatus 1 may include only one type or only two types of polishing modules M. Also, the substrate processing apparatus 1 may include a polishing module M different from any of the surface polishing module M1, the bevel polishing module M2, and the back surface polishing module M3.

Also, the substrate processing apparatus 1 in the above-described embodiment includes the measurement unit 53 that measures a state of defects remaining on the substrate W after undergoing processing such as polishing, but an example of the substrate processing apparatus 1 is not limited thereto. For example, a measurement unit for measuring a state of processing by the polishing module M may be individually provided for each of the plurality of polishing modules M.

Also, the number of polishing modules M included in each of the lanes L1U, L1D, L2U, and L2D is not limited to the illustrated example, and may be changed as appropriate.

Also, the lanes L1U, L1D, L2U, and L2D in which a disposition order of the polishing modules M cannot be changed may be present.

Also, the polishing module M does not necessarily have to be configured to be attachable to and detachable from the transport unit C.

Also, the filter fan unit F does not necessarily have to be provided in each housing 31. For example, one filter fan unit F may be provided for a plurality of housings 31.

Also, the housing 31 does not necessarily have to be exposed to the outside. In other words, the housing 31 may be housed in the outer housings H1 and H2.

In the substrate processing apparatus 1 according to the present embodiment, the transport unit C (first transport unit C1) includes the upper movement rail 61 and the lower movement rail 62, but the substrate processing apparatus may also be configured without movement rails.

In the substrate processing apparatus 1 according to the present embodiment, the numbers of upper transport devices 52U and lower transport devices 52D are each one, but the numbers of upper transport devices and lower transport devices may each be a plurality (any number of two or more). When there are a plurality of upper transport devices, transfer of the first substrate may be performed among the upper transport devices. When there are a plurality of lower transport devices, transfer of the second substrate may be performed among the lower transport devices.

In addition, the components in the above-described embodiment may be appropriately replaced with well-known components within a range not departing from the spirit of the present invention, and the above-described embodiment and modified examples may be appropriately combined.

### REFERENCE SIGNS LIST

1 Substrate processing apparatus
31 Housing
31a Opening
52U Upper transport device
52D Lower transport device
61 Upper movement rail
62 Lower movement rail
C, C11, C12, C13, C14 Transport unit
M Polishing module
M1 Surface polishing module
M2 Bevel polishing module
M3 Back surface polishing module
F Filter fan unit
G1 First module group
G2 Second module group
L1U First upper lane (upper lane)
L1D First lower lane (lower lane)
L2U Second upper lane (upper lane)
L2D Second lower lane (lower lane)
W1 First substrate
W2 Second substrate
Y Transport direction

## Claims

1. A substrate processing apparatus comprising:
a plurality of polishing modules polishing a substrate; and
a transport unit moving the substrate among the plurality of polishing modules, wherein
the plurality of polishing modules include a first module group and a second module group,
the transport unit is positioned between the first module group and the second module group in a plan view,
the first module group includes a first upper lane in which at least two of the polishing modules are disposed adjacent to each other, and a first lower lane in which at least two of the polishing modules are disposed adjacent to each other and which is disposed below the first upper lane, and
the second module group includes a second upper lane in which at least two of the polishing modules are disposed adjacent to each other, and a second lower lane in which at least two of the polishing modules are disposed adjacent to each other and which is disposed below the second upper lane.

2. The substrate processing apparatus according to claim 1, wherein the polishing module has a housing exposed to the outside.

3. The substrate processing apparatus according to claim 2, wherein the housing has an opening formed for moving the substrate between the transport unit and the polishing module.

4. The substrate processing apparatus according to claim 2 or 3, wherein a filter fan unit is provided in the housing.

5. The substrate processing apparatus according to any one of claims 1 to 3, wherein the polishing module is connected to a side surface of the transport unit.

6. The substrate processing apparatus according to any one of claims 1 to 3, wherein the polishing module is configured to be attachable and detachable.

7. The substrate processing apparatus according to claim 5, wherein in at least one of the first upper lane, the first lower lane, the second upper lane, and the second lower lane, an order in which at least two of the polishing modules are disposed is changeable.

8. The substrate processing apparatus according to any one of claims 1 to 3, wherein
the plurality of polishing modules include:
at least one surface polishing module polishing a surface of the substrate;
at least one bevel polishing module polishing a bevel portion of the substrate; and
at least one back surface polishing module polishing a back surface of the substrate.

9. A substrate processing apparatus comprising:
a transport unit including an upper transport device transporting a first substrate and a lower transport device transporting a second substrate;
an upper lane including a plurality of polishing modules which are provided to be arranged in a transport direction of the upper transport device and polish the first substrate; and
a lower lane including a plurality of polishing modules which are provided to be arranged in a transport direction of the lower transport device and polish the second substrate, wherein
the polishing modules are attachable to and detachable from the transport unit,
the upper lane and the lower lane are disposed in parallel at different height positions,
the upper transport device performs transfer of the first substrate between itself and the upper lane, and
the lower transport device performs transfer of the second substrate between itself and the lower lane.

10. The substrate processing apparatus according to claim 9, wherein
the transport unit further includes:
an upper movement rail extending in a transport direction of the upper transport device; and
a lower movement rail extending in a transport direction of the lower transport device,
the upper transport device is movable along the upper movement rail, and
the lower transport device is movable along the lower movement rail.

11. The substrate processing apparatus according to claim 9, comprising a plurality of the transport units, wherein
the plurality of transport units are arranged in a transport direction of the upper transport device and the lower transport device.

12. The substrate processing apparatus according to any one of claims 9 to 11, wherein
the polishing modules constituting the upper lane include:
at least one surface polishing module polishing a surface of the first substrate;
at least one back surface polishing module polishing a back surface of the first substrate; and
at least one bevel polishing module polishing a bevel portion of the first substrate, and
the polishing modules constituting the lower lane include:
at least one surface polishing module polishing a surface of the second substrate;
at least one back surface polishing module polishing a back surface of the second substrate; and
at least one bevel polishing module polishing a bevel portion of the second substrate.
